# EUROPEAN PATENT APPLICATION

(11) **EP 1 484 825 A2**
(43) Date of publication of application: **08.12.2004**
(21) Application number: 04009128.2
(22) Date of filing: 16.04.2004
(51) Int. Cl.: H01S 5/068

(54) **Laser diode protection circuit**

(30) Priority: 02.06.2003 KR 2003035274
(71) Applicant: Samsung Electronics Co., Ltd., Suwon-si, Gyeonggi-do (KR)
(72) Inventor:
(74) Representative: Grünecker, Kinkeldey, Stockmair & Schwanhäusser Anwaltssozietät

(57) **Abstract**

A circuit for protecting a laser diode from an initial instantaneous surge current includes an upper voltage limiter (100) for applying a predetermined voltage to a laser diode (D1) and limiting the voltage not to exceed a predetermined level and further features a low-speed voltage increaser (200) for slowly increasing a voltage to be applied to the upper voltage limiter (100) by a predetermined time constant. For ATC (automatic temperature control), the laser diode protection circuit may further comprise a lower voltage limiter (300), a low-speed voltage reducer (400) and a second leakage current breaker (450).

## Description

### BACKGROUND OF THE INVENTION

### 1. Field of the Invention

The present invention relates to a laser diode ("LD") protection circuit, and more particularly to a circuit for protecting a laser diode from an initial instantaneous surge current.

### 2. Description of the Related Art

DM-DFB LDs (directly modulated-distributed feedback laser diodes) and EM-DFB LDs (electro-absorption modulated-distributed feedback laser diodes) have maximum allowable currents in the forward direction. An excessive current overshooting the maximum level may greatly damage the LDs.

In order to prevent any change of output (optical power) which may be caused by a change of external temperature or the like, an LD generally uses an APC (automatic power control ) or ATC (automatic temperature control) circuit. However, an unexpected, instantaneous surge current may flow until the APC is stabilized after initial power supply. If no protection circuit is provided to prevent the surge current, the LD may be greatly damaged. For this reason, a voltage limiter, which can prevent a voltage from flowing in excess of a predetermined level, is used. However, even the voltage limiter cannot protect a chip from an instantaneous surge current when applying initial power.

### SUMMARY OF THE INVENTION

The present invention has been made to solve the above-mentioned problems occurring in the prior art, and is directed to providing a circuit for protecting a laser diode from an initial instantaneous surge current.

In one aspect of the present invention, the laser diode protection circuit includes an upper voltage limiter for applying a predetermined voltage to a laser diode and limiting the voltage not to exceed a predetermined level. The circuit also feature a low-speed voltage increaser for slowly increasing a voltage to be applied to the upper voltage limiter by a predetermined time constant.

### BRIEF DESCRIPTION OF THE DRAWINGS

The above and other objects, features and advantages of the present invention will be more apparent from the following detailed description taken in conjunction with the accompanying drawings, in which:
FIG 1 is a schematic diagram showing the configuration of a conventional laser diode to which the present invention is applicable.
FIG 2 is a schematic diagram showing the configuration of a laser diode protection circuit according to a first embodiment of the present invention.
FIG 3 is a schematic diagram showing the configuration of a laser diode protection circuit according to a second embodiment of the present invention.
FIG 4 is a graph showing the changes of upper and lower limit voltages with time according to the first and second embodiments of the present invention.

### DETAILED DESCRIPTION OF THE PREFERRED EMBODIMENT

Hereinafter, preferred embodiments of the present invention will be described with reference to the accompanying drawings. In the drawings, the same element, although depicted in different drawings, will be designated by the same reference numeral or character. Although certain elements such as a circuit device are specifically defined in the following description of the present invention, it will be obvious to those skilled in the art that such definitions of elements are merely to improve understanding of the present invention and that the present invention can be carried out without such specific elements. Also, in the following description of the present invention, a detailed description of known functions and configurations incorporated herein will be omitted when it may make the subject matter of the present invention rather unclear.

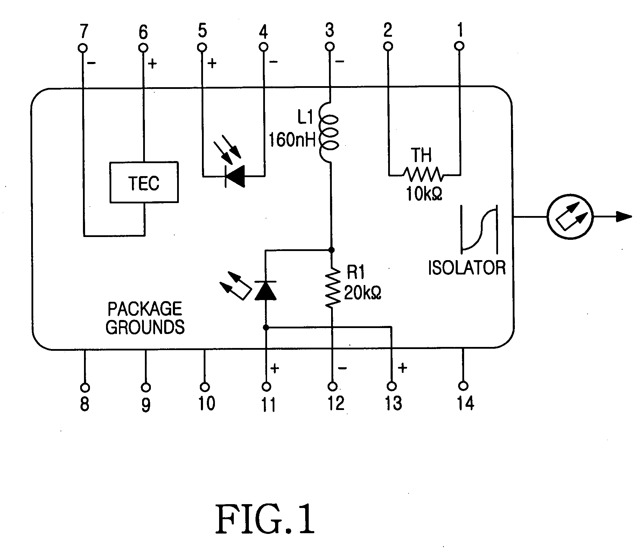

FIG. 1 shows the configuration of a conventional laser diode to which the present invention is applicable. The laser diode depicted in FIG. 1 is "D2526" of TriQuint, U.S.A.

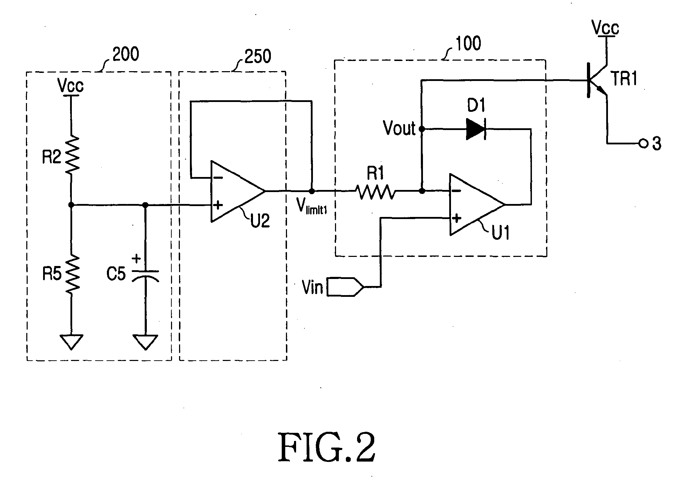

FIG. 2 shows the configuration of a laser diode protection circuit according to the first embodiment of the present invention. The depicted circuit considers APC only.

An upper voltage limiter 100 is designed so that output voltage (Vout) of the limiter cannot exceed a predetermined level. The upper voltage limiter 100 is connected to a base terminal of a first power transistor TR1. An emitter is connected to a pin of the LD, which is numbered 3 in FIG. 1. The pin 3 is a DC bias terminal. The upper voltage limiter 100 consists of a first operation amplifier U1, a resistor R1 and a first diode D1.

A low-speed voltage increaser 200 slowly increases a voltage to be applied to the upper voltage limiter 100 by a predetermined time constant when power Vcc is applied. The time constant is set by a resistor R2 and a capacitor C5. Another resistor R5 is connected to the resistor R2 for voltage division.

A first leakage current breaker 250 is placed between the upper voltage limiter 100 and the low-speed voltage increaser 200. The first leakage current breaker 250 includes a second operation amplifier U2 which has an inverting terminal (-) for feed backing an output and a non-inverting terminal (+) connected to the low-speed voltage increaser 200.

The first and second operation amplifiers U1 and U2 can each be implemented as a "LF347" (Quad Operational Amplifier; JFET) of FAIRCHILD, for example.

The first diode D1 of the upper voltage limiter 100 turns on when a limiting voltage Vₗᵢₘᵢₜ is equal to or higher than the output voltage Vout. At this time, the upper voltage limiter 100 functions as a buffer which makes the input voltage (a voltage Vin applied to the non-inverting terminal (+) of the first operation amplifier U1) and the output voltage become equal. Conversely, the first diode D1 turns off when the limiting voltage Vₗᵢₘᵢₜ is lower than the output voltage Vout. Since the direction of current changes at this time, the upper voltage limiter 100 cannot function as a buffer and therefore a leakage current flows. The output voltage Vout is equal to the limiting voltage Vₗᵢₘᵢₜ minus the voltage (i_{leakage} x R1) loaded by the resistor R1 due to the leakage current. The first leakage current breaker 250 is needed to prevent such an event, i.e., the output voltage Vout from becoming lower than the limiting voltage Vₗᵢₘᵢₜ.

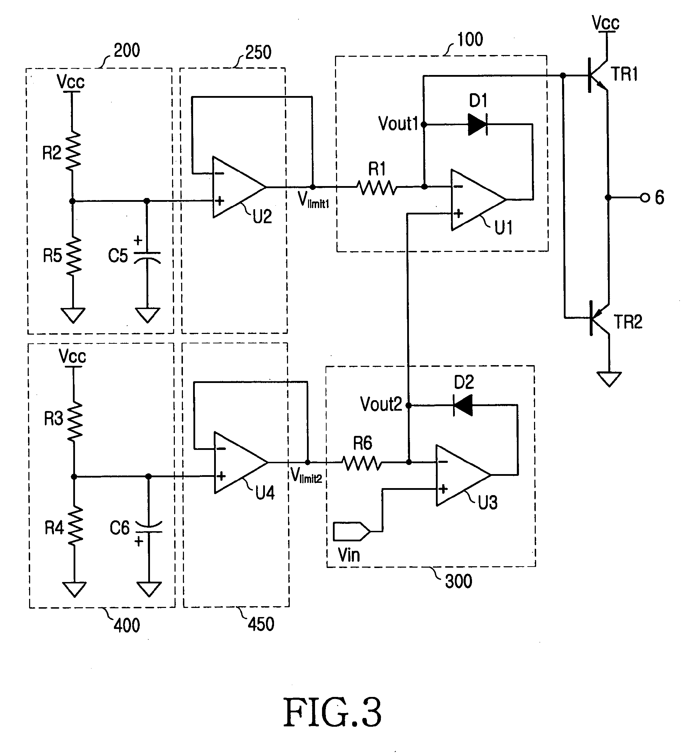

FIG. 3 shows the configuration of a laser diode protection circuit according to the second embodiment of the present invention, which implements ATC in addition to APC.

The laser diode protection circuit according to the second embodiment includes a lower voltage limiter 300, a low-speed voltage reducer 400 and a second leakage current breaker 450, in addition to the elements as shown in FIG. 2. However, the upper voltage limiter 100 is connected to the base terminals of the first and second power transistors TR1 and TR2, while the emitter of the first power transistor TR1 and the collector of the second power transistor TR2 are connected to a pin of the LD, which is numbered 6 in FIG. 1. The pin 6 is a thermoelectric cooler (+) terminal.

This configuration limiting the lower voltage is for ATC (automatic temperature control).

An output voltage (Vout2) of the lower voltage limiter 300 does not drop below a predetermined level. The lower voltage limiter 300 includes: a third operation amplifier U3 having an inverting terminal (-) connected to the low-speed voltage reducer 400 via the resistor R6 and the second leakage current breaker 450, and a non-inverting terminal (+) to which power is applied. The lower voltage limiter 300 is further comprised of a second diode D2 which has a cathode connected to the inverting terminal (-) of the third operation amplifier U3 and the non-inverting terminal (+) of the first operation amplifier U1 and an anode connected to the output terminal of the third operation amplifier U3.

The low-speed voltage reducer 400 consists of a resistor R3 and a capacitor C6 which set a time constant to slowly drop a voltage to be applied to the lower voltage limiter 300, without generating an initial instantaneous surge current. The second leakage current breaker 450 is placed between the lower voltage limiter 300 and the low-speed voltage reducer 400 in order to block a current leaking from the lower voltage limiter 300. The second leakage current breaker 450 accomplishes the latter through use of a fourth operation amplifier U4 having an inverting terminal (-) to feed back an output supplied to the lower voltage limiter 300 and a non-inverting terminal (+) connected to the low-speed voltage reducer 400.

The third and fourth operation amplifiers U3 and U4 can each be implemented as a "LF347" of FAIRCHILD, for example.

The second diode D2 of the lower voltage limiter 300 turns on when a limiting voltage Vₗᵢₘᵢₜ₂ is lower than an output voltage Vout2. At this time, the lower voltage limiter 300 functions as a buffer which makes the input voltage (a voltage Vin applied to the non-inverting terminal (+) of the third operation amplifier U3) equal to the output voltage Vout2. Conversely, the second diode D2 turns off when the limiting voltage Vₗᵢₘᵢₜ₂ is equal to or higher than the output voltage Vout2. Since the direction of current changes at this time, the lower voltage limiter cannot function as a buffer and therefore a leakage current flows. The output voltage Vout2 is equal to the limiting voltage Vₗᵢₘᵢₜ₂ minus the voltage (i_{leakage} x R6) loaded by the resistor R6 due to the leakage current. The second leakage current breaker 450 is needed order to prevent such an event, i.e., the output voltage Vout2 from becoming lower than the limiting voltage Vₗᵢₘᵢₜ₂.

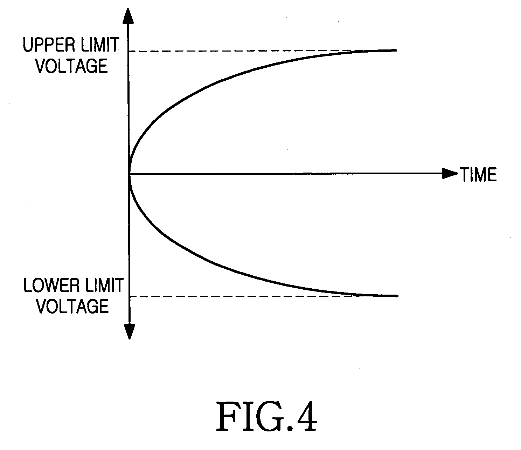

FIG 4 is a graph showing the changes of upper and lower limit voltages with time according to the first and second embodiments of the present invention.

As shown, the upper limit voltage and the lower limit voltage slowly increase or decrease with the lapse of time. The upper limit voltage slowly increases by a time constant defined by the resistance and capacitance of the resistor R2 and the capacitor C5, respectively. Correspondingly, the lower limit voltage slowly decreases by a time constant defined by the resistor R3 and the capacitor C6. It is accordingly possible to prevent an instantaneous surge current from flowing in the LD during initial supply of power.

As described above, the present invention can prevent damage to an expensive DM-DFB or EM-DFB LDs which may be caused by an initial instantaneous surge current. Also, the present invention can prevent important parts from being damaged in a feedback circuit during initial stabilization.

While the invention has been shown and described with reference to certain preferred embodiments thereof, it will be understood by those skilled in the art that various changes in form and details may be made therein without departing from the spirit and scope of the invention as defined by the appended claims.

## Claims

1. A laser diode protection circuit comprising:
an upper voltage limiter (100) for applying a predetermined voltage to a laser diode and limiting the voltage not to exceed a predetermined level; and
a low-speed voltage increaser (200) for retarding an increase in voltage to be applied to the upper voltage limiter (100) in accordance with a predetermined time constant.

2. The laser diode protection circuit according to claim 1, wherein said upper voltage limiter (100) comprises:
a first operation amplifier (U1) having an inverting terminal connected to said low-speed voltage increaser (200) through a predetermined resistor (R1) and having a non-inverting terminal to which a predetermined voltage is applied; and
a first diode (D1) having an anode connected to said inverting terminal and to a base terminal of a power transistor (TR1) connected to a DC bias terminal of said laser diode, and having a cathode connected to an output terminal of said first operation amplifier (U1).

3. The laser diode protection circuit according to claim 1 or 2, wherein said low-speed voltage increaser (200) comprises a resistor (R2, R5) and a capacitor (C5) whose respective resistance and capacitance define said time constant so that the retarding prevents an initial instantaneous surge current.

4. The laser diode protection circuit according to claim 1, 2, or 3 further comprising a first leakage current breaker (250) that is placed between said upper voltage limiter (100) and said low-speed voltage increaser (200) in order to block a current leaking from said upper voltage limiter (100).

5. The laser diode protection circuit according to claim 4, wherein said first leakage current breaker (250) for blocking a current leaking from said upper voltage limiter (100) uses a second operation amplifier (U2) that has an inverting terminal (-) for feeding back an output supplied to the upper voltage limiter (100) and a non-inverting terminal (+) connected to the low-speed voltage increaser (200).

6. A laser diode protection circuit according to any one of the previous claims, further comprising:
a lower voltage limiter (300) for limiting a voltage applied to the laser diode not to drop below a predetermined level; and
a low-speed voltage reducer (400) for retarding a drop in voltage to be applied to the lower voltage limiter (300) in accordance with a predetermined time constant.

7. The laser diode protection circuit according to one of claims 2 to 6, wherein the anode of the first diode (D1) is further connected to the base terminal of a second power transistor (TR2) connected to a thermoelectric cooler (+) terminal of said laser diode.

8. The laser diode protection circuit according to claim 6 or 7, wherein said lower voltage limiter (300) comprises:
a third operation amplifier (U3) having an inverting terminal connected to said low-speed voltage reducer (400) via a predetermined resistor (R6) and having a non-inverting terminal to which power is applied; and
a second diode (D2) having a cathode connected to the inverting terminal of said third operation amplifier (U3) and to the non-inverting terminal of said first operation amplifier (U1), and having an anode connected to an output terminal of said third operation amplifier (U3).

9. The laser diode protection circuit according to claim 6, 7 or 8 , wherein said low-speed voltage reducer (400) comprises a resistor (R3, R4) and a capacitor (C6) having a respective resistance and capacitance that define said second predetermined time constant so that the retarding of the drop prevents an initial instantaneous surge current.

10. The laser diode protection circuit according to claim 6, 7, 8 or 9, further comprising a second current leakage breaker (450) which is placed between said lower voltage limiter (300) and said low-speed voltage reducer (400) in order to block a current leaking from said lower voltage limiter (300).

11. The laser diode protection circuit according to claim 10, wherein said second leakage current breaker (450) for blocking a current leaking from said lower voltage limiter (300), uses a fourth operation amplifier (U4) that has an inverting terminal (-) for feeding back an output supplied to said lower voltage limiter (300) and that has a non-inverting terminal (+) connected to said low-speed voltage reducer (400).

12. A laser diode protection method comprising the steps of:
a) selectively changing a voltage by, if a voltage exceeds a predetermined limit, limiting the voltage to the predetermined limit and otherwise, if the voltage does not exceed the predetermined limit, not limiting the voltage to the predetermined limit;
b) in accordance with a predetermined time constant, retarding an increase in the voltage to be selectively changed in step a); and
c) applying to a laser diode the voltage which has been selectively changed in step a) by being limited or not being limited.

13. The method of claim 12, wherein step a) further includes the steps of:
providing a laser diode with a DC bias terminal;
providing a power transistor (TR1) with a base terminal;
providing a predetermined resistor (R1);
providing a low-speed voltage increaser (200);
providing a first operation amplifier (U1) having an inverting terminal, a non-inverting terminal to which a predetermined voltage is applied and an output terminal;
connecting the inverting terminal to the low-speed voltage increaser (200) through the predetermined resistor (R1);
providing a diode (D1) having an anode and a cathode;
connecting said anode to said inverting terminal and to said base terminal; and
connecting said cathode to said output terminal.

14. The method of claim 13, wherein step b) is executed by said low-speed voltage increaser (200).

15. The method of claim 13 or 14, wherein said low-speed voltage (200) increaser comprises a resistor (R2, R5) and a capacitor (C5) whose respective resistance and capacitance define said time constant so that the retarding prevents an initial instantaneous surge current.

16. The method of claim 13, 14 or 15, wherein step a) is executed by an upper voltage limiter (100) and wherein said method further comprising the step of:
blocking a current leaking from said upper voltage limiter (100), using a second operation amplifier (U2) that has an inverting terminal (-) for feeding back an output supplied to the upper voltage limiter (100) and a non-inverting terminal (+) connected to the low-speed voltage increaser (200).
